(19) Europäisches Patentamt
European Patent Office
Office européen des brevets

(11) **EP 3 437 141 B1**

(12) **EUROPEAN PATENT SPECIFICATION**

(45) Date of publication and mention
of the grant of the patent:
**05.08.2020 Bulletin 2020/32**

(21) Application number: **17718422.3**

(22) Date of filing: **06.03.2017**

(51) Int Cl.:
*H01L 31/0224* (2006.01)    *H01L 31/18* (2006.01)

(86) International application number:
**PCT/IT2017/000044**

(87) International publication number:
**WO 2017/168456 (05.10.2017 Gazette 2017/40)**

(54) **PROCESS FOR COVERING A PHOTOVOLTAIC SURFACE**

VERFAHREN ZUR ABDECKUNG EINER FOTOVOLTAISCHEN OBERFLÄCHE

PROCÉDÉ DE RECOUVREMENT D'UNE SURFACE PHOTOVOLTAÏQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2016 IT UA20162095**

(43) Date of publication of application:
**06.02.2019 Bulletin 2019/06**

(73) Proprietors:
• **Chiara, Fabrizio**
**10070 San Francesco al Campo (TO) (IT)**
• **Casellato, Giancarlo**
**10141 Torino (IT)**

(72) Inventors:
• **Chiara, Fabrizio**
**10070 San Francesco al Campo (TO) (IT)**
• **Casellato, Giancarlo**
**10141 Torino (IT)**

(74) Representative: **Garavelli, Paolo**
**A.BRE.MAR. S.R.L.**
**Consulenza in Proprietà Industriale**
**Via Servais 27**
**10146 Torino (IT)**

(56) References cited:
**US-A1- 2008 230 118    US-A1- 2011 041 890**
**US-A1- 2013 291 932    US-B1- 8 569 096**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention refers to a process for covering a photovoltaic surface, in particular through an embodiment and an application of a graphic representation on such photovoltaic surface and to a photovoltaic surface made through such process. The document US2008/0230118A is a related prior art.

Today the use of alternative technologies is more and more widespread: in particular, an optical-electronic device, such as a photovoltaic or solar panel, is known, composed of photovoltaic or solar cells, capable of converting the incident sun energy into electric energy through a photovoltaic effect, and it is typically used as current generator in a photovoltaic or solar plant.

The strong diffusion and installation of photovoltaic or solar panels in a plurality of external and internal environments, such as for example gardens, plane or incline roofs, shelters, etc. is also known, implying a high visual impact.

Moreover, photovoltaic and solar panels are known, mainly of a dark colour, which enable the process of converting solar Energy, but prevent its camouflaging with the surrounding environment in which they are installed.

A device is also known, like the one described, for example, in patent US2016072430, composed of a solar panel, of a transparent slab equipped on the external surface with a printed image and inside with a plurality of optical means adapted to re-address the luminous rays on the printed image on the slab surface. Moreover, this printed image is composed of opaque or semitransparent areas, separated by totally transparent areas or micro-holes. Such device enables the illumination of the printed image on the slab surface, but does not ensure a high efficiency of use of the solar panel; moreover, such solar panel is designed for a particular graphic element, limiting the applicability of the device.

A technologic process is also known in the art, characterized by a production of a solar ink capable of capturing light and convert it into electricity. The technologic process is performer with suitable printers, through a digital printing technique, which can be applied on multiple surfaces, such as for example a surface made of PET (polyethylene terephtalate) plastic, through the distribution of solar ink, performing the transformation of such PET plastic surface into a photovoltaic panel. The known technologic process implies a low production and process cost, the use of daily used materials, and a practical application use, but it is not able to guarantee photovoltaic panels with high performances, comparable with the power delivered by those normally known in the art.

It is clear from the known prior art that currently the photovoltaic or solar devices have a strong visual impact, preventing the integration in environments where aesthetic and design are required, and the proposed solutions to reduce such visual impact do not guarantee an operating conversion efficiency.

Therefore, object of the present invention is solving the above prior art problems by providing a process capable of covering a photovoltaic surface with a graphic representation.

Another object is providing a graphic element equipped with empty and filled areas capable of guaranteeing a high operating efficiency for converting the photovoltaic surface.

The object of the present invention is only and solely as defined in the appended claims. Any further statements in this description referring to the invention are to be interpreted so that the invention is solely as defined in the claims.

It is intended that all enclosed claims are an integral part of the present description.

It will be immediately obvious that numerous variations and modifications (for example related to shape, sizes, arrangements and parts with equivalent functionality) could be made to what is described, without departing from the scope of the invention as appears from the enclosed claims.

The present invention will be better described by some preferred embodiments thereof, provided as a non-limiting example, with reference to the enclosed drawings, in which:

- Figures 1 and 2 show front views of a preferred embodiment of components of the process for covering a photovoltaic surface according to the present invention; and
- Figures 3 to 5 show front views of three preferred embodiments of components of the process for covering a photovoltaic surface according to the present invention.

With reference to the Figures, it is possible to note that the process for covering at least one photovoltaic, rigid or flexible surface and, advantageously, any surface adapted to convert a radiation of the optical spectrum such as infrared, or ultraviolet, etc. into electricity to obtain an optimization of the operating conversion efficiency of such photovoltaic surface with at least one graphic representation, substantially comprises the steps of:

- providing at least one graphic representation and at least one photovoltaic surface on which such graphic representation has to be applied;
- making at least one graphic grid 1 composed of at least one empty area B and at least one filled area D: preferably, a percentage ratio E between such areas B, D is included between 10% and 90%;

- associating the graphic representation to the graphic grid 1 to obtain such perforated graphic representation (virtually or materially) according to such areas B, D; and

- at least partially covering such photovoltaic surface with such perforated graphic representation.

In particular, the perforated graphic representation can advantageously be applied as covering of such photovoltaic surface through:

- directly printing with the insertion of the photovoltaic surface inside a suitable printer, such as, for example, a ROLAND VersaUV LEF-20 printer with UV inks or other similar one, with possible following covering with at least one transparent protecting layer; and/or
- separately making the perforated graphic representation with suitable removal of the empty areas B from the filled areas D according to the graphic grid 1 and afterwards gluing onto the photovoltaic surface; and/or
- printing the perforated graphic representation on a suitably transparent support to be glued or mechanically or chemically fastened onto the photovoltaic surface.

The process according to the present invention further comprises the steps of:

- defining at least one elementary graphic element 2 such as, for example, a pattern element or other suitable one;
- making such graphic grid 1 composed of a plurality of such elementary graphic elements 2.

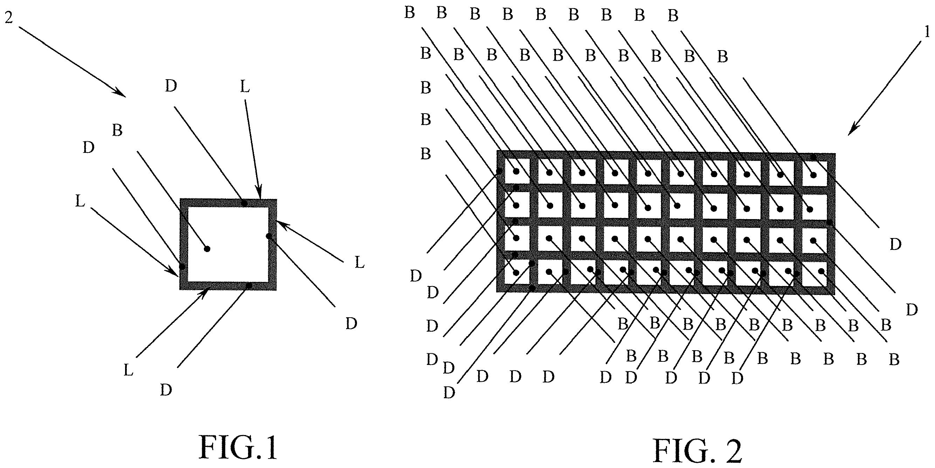

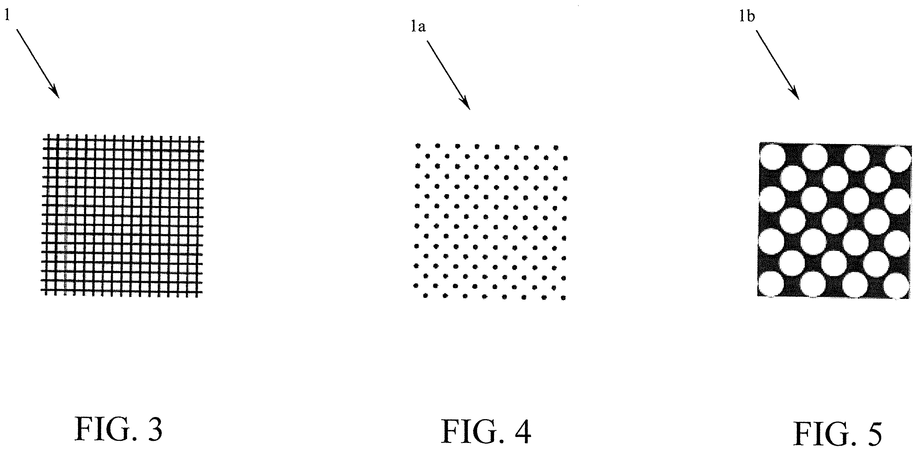

In particular, the graphic grid 1 can be composed of a plurality of such elementary graphic elements 2 like, for example, a grid with a rectangular, hexagonal, circular, square or other similar shape, or with an arrangement with dimples 1a, as shown in Figure 2, or with an arrangement with negative dimples 1b, as shown in Figure 3.

As shown in Figure 2, the graphic grid 1 can be obtained through a repetition of the elementary graphic element 2 along the three space directions and, in particular, obtained through a rotary symmetry if the elementary graphic element 2 is repeated around a rotation centre, or through a translation symmetry if the elementary graphic element 2 is repeated through movement along a line or a surface, or through mirror symmetry if the elementary graphic element 2 is repeated through an overturning with respect to a rotation axis.

In particular, the graphic grid 1, or the single elementary graphic element 2, is defined through a suitable development tool such as, for example, Photoshop, or Corel Draw, or GIMP (GNU Image Manipulation Program) or other similar one, so that it is equipped with at least one empty area B adapted to enable the incidence of the sun light on the photovoltaic surface and with at least one filled area D adapted to compose the application zone of the graphic representation; consequently, the elementary graphic element 2 and the related graphic grid 1 are equipped with empty and filled areas according to a percentage ratio E included between value 10% and value 90%, enabling the optimization of the operating conversion efficiency of the photovoltaic surface covered with the graphic elemento through such process for covering.

Figure 1 shows, the elementary graphic element 2 having a square shape, equipped with a total area A equal to the square of a size of the side L of the elementary graphic element 2, according to a first relationship $A = L^2$ ; and equipped with an empty area B related to the size of the side L and to a size of the filled area D of the elementary graphic element 2, represented by the thickness of the side L of the total area A, according to a second relationship equal to $B = (L-2D)^2$. The percentage ratio E characterizing the elementary graphic element 2 is equal to a ratio between empty area B and total area A, according to a third relationship equal to

$$E = \frac{(L - 2D)^2}{L^2}$$

In particular, the size of the side L of the total area A of the elementary graphic element 2 is such as to make the elementary graphic element 2, at the end of the process for covering the photovoltaic surface, not capable of being visually distinguished from the graphic representation, allowing a sharp display of the representation itself.

## Claims

1. Process for covering at least one photovoltaic surface comprising the steps of:

   - providing at least one graphic representation and at least one photovoltaic surface, said graphic representation being adapted to confer aesthetic properties to said photovoltaic surface;
   - making at least one graphic grid (1) composed of at least one empty area (B) and at least one filled area (D);
   - associating said graphic representation to said graphic grid (1) to obtain a perforated graphic representation according to said areas (B, D); and
   - covering at least partially said photovoltaic surface with said perforated graphic representation,
   wherein the percentage ratio (E) between said areas (B, D) is included between 10% and 90%, and further comprising the steps of:

      - defining at least one elementary graphic element (2);

- making said graphic grid (1) composed of a plurality of said elementary graphic elements (2), said elementary graphic element (2) being a square equipped with a total area (A) equal to the square of at least one size of the side (L) of said elementary graphic element (2), according to a first relationship $A = L^2$ and equipped with at least one empty area (B) related to said size of said side (L) and at least the size of at least one filled area (D) of said elementary graphic element (2), equal to at least the thickness value of said side (L) of said total area (A), according to the second relationship $B = (L-2D)^2$.

2. Process according to claim 1, **characterized in that** said empty area (B) is adapted to enable an incidence of sun light on said photovoltaic surface and said filled area (D) is adapted to compose an application zone of said graphic representation.

3. Process according to claim 1, **characterized in that** said perforated graphic representation is applied as covering for said photovoltaic surface through:

   - directly printing through an insertion of said photovoltaic surface inside at least one printer; and/or
   - separately making said graphic representation with suitable removal of said empty areas (B) from said filled areas (D) according to said graphic grid (1) and afterwards gluing onto said photovoltaic surface; and/or
   - printing said perforated graphic representation on at least one suitably transparent support to be glued or fastened onto said photovoltaic surface.

4. Process according to claim 1, **characterized in that** said graphic grid (1) is obtained through a repetition of said elementary graphic element (2) along three space directions, through at least one rotary symmetry if said elementary graphic element (2) is repeated around and at least one rotation centre, or through a translation symmetry if said elementary graphic element (2) is repeated through at least one movement along a line, or through a mirror symmetry if said elementary graphic element (2) is repeated through at least one overturning with respect to a rotation axis.

5. Process according to the previous claim, **characterized in that** said elementary graphic element (2) has at least one value of said percentage ratio (E) equal to at least one ratio between said empty area (B) and said total area (A), according to a third relationship

$$E = \frac{(L - 2D)^2}{L^2}.$$

**Patentansprüche**

1. Beschichtungsverfahren von mindestens einer Photovoltaikfläche, das folgende Phasen enthält:

   - mindestens eine grafische Darstellung und mindestens eine Photovoltaikfläche vorsehen, die genannte grafische Darstellung dient dazu, der genannten Photovoltaikfläche ästhetische Eigenschaften zu verleihen;
   - mindestens ein grafisches Gitter (1) realisieren, das aus mindestens einem leeren Bereich (B) und mindestens einem vollen Bereich (D) besteht;
   - die genannte grafische Darstellung mit dem genannten grafischen Gitter (1) verbinden, um eine durchlochte grafische Darstellung gemäß den genannten Bereichen (B, D) zu erhalten; und
   - die genannte Photovoltaikfläche mindestens teilweise mit der genannten durchlochten grafischen Darstellung beschichten, wobei das Prozentverhältnis (E) zwischen den genannten Bereichen (B, D) zwischen 10% und 90% liegt und außerdem folgende Phasen einschließt:

      - mindestens ein grafisches Grundelement (2) definieren;
      - das genannte grafische Gitter (1) realisieren, das aus einer Vielzahl der genannten grafischen Grundelemente (2) besteht, das genannte grafische Grundelement (2) ist ein Quadrat, das mit einem Gesamtbereich (A) ausgestattet ist, der gemäß einem ersten Verhältnis **A = L²** mindestens einer Abmessung der Seite (L) des genannten grafischen Grundelements (2) entspricht, es ist mit mindestens einem leeren Bereich (B) ausgestattet, der mit der genannten Abmessung der genannten Seite (L) und mindestens mit der Abmessung von mindestens einem vollen Bereich (D) des genannten grafischen Grundelements (2) verbunden ist, und entspricht mindestens dem Wert der Stärke der genannten Seite (L) des genannten Gesamtbereiches (A) gemäß dem zweiten Verhältnis **B = (L-2D)²**.

2. Verfahren gemäß Patentanspruch 1, das **dadurch gekennzeichnet ist, dass** der genannte leeren Bereich (B) dazu dient, den Einfall des Sonnenlichtes auf die genannte Photovoltaikfläche zu fördern, und der genannte volle Bereich (D) dient dazu, einen Anwendungsbereich der genannten grafischen Darstellung darzustellen.

**3.** Verfahren gemäß Patentanspruch 1, das **dadurch gekennzeichnet ist, dass** die genannte durchlochte grafische Darstellung als Beschichtung der genannten Photovoltaikfläche angewendet wird durch:

- Direktformen durch mindestens eine Einführung der genannten Photovoltaikfläche in mindestens einen Drucker; und/oder
- getrennte Realisierung der genannten grafischen Darstellung mit entsprechender Abtragung der genannten leeren Bereiche (B) von den genannten vollen Bereichen (D) gemäß dem genannten grafischen Gitter (1) und nachfolgendem Aufkleben auf die genannte Photovoltaikfläche; und/oder
- Formen der genannten durchlochten grafischen Darstellung auf mindestens einem entsprechend transparenten Träger, der auf die genannte Photovoltaikfläche geklebt oder auf dieser befestigt werden muss.

**4.** Verfahren gemäß Patentanspruch 1, das **dadurch gekennzeichnet ist, dass** das genannte grafische Gitter (1) durch die Wiederholung des genannten grafischen Grundelements (2) in drei Richtungen im Raum erhalten wird, durch mindestens eine Rotationssymmetrie, wenn das genannte grafische Grundelement (2) im Bereich von mindestens einem Rotationszentrum wiederholt wird, oder durch eine Verschiebungssymmetrie, wenn das genannte grafische Grundelement (2) durch mindestens eine Verschiebung längs einer Linie wiederholt wird, oder durch eine Spiegelsymmetrie, wenn das genannte grafische Grundelement (2) durch mindestens ein Umkippen gegenüber einer Rotationsachse wiederholt wird.

**5.** Verfahren gemäß dem vorhergehenden Patentanspruch, das **dadurch gekennzeichnet ist, dass** das genannte grafische Grundelement (2) mindestens einen Wert des genannten Prozentverhältnisses (E) entsprechend mindestens einem Verhältnis zwischen dem genannten leeren Bereich (B) und dem genannten Gesamtbereich (A) gemäß einem dritten Verhältnis hat $E = \dfrac{(L-2D)^2}{L^2}$

**Revendications**

**1.** Procédé de recouvrement au moins d'une surface photovoltaïque comprenant les phases suivantes :

- prévoir au moins une représentation graphique et au moins une surface photovoltaïque ; la représentation graphique étant apte à conférer des propriétés esthétiques à la surface photovoltaïque ;
- réaliser au moins une grille graphique (1) composée au moins d'une zone vide (B) et d'une zone pleine (D) ;
- associer la représentation graphique à la grille graphique (1) pour obtenir une représentation graphique perforée selon les zones (B, D) ; et
- recouvrir au moins partiellement la surface photovoltaïque avec la représentation graphique perforée où le rapport en pourcentage (E) entre les zones (B, D) est compris entre 10% et 90%, et

comprenant par ailleurs les phases suivantes :

- définir au moins un élément graphique élémentaire (2) ;
- réaliser la grille graphique (1) composée d'une pluralité d'éléments graphiques élémentaires (2),

l'élément graphique élémentaire (2) étant un carré doté d'une surface totale (A) égale au carré au moins d'une dimension du côté (L) de l'élément graphique élémentaire (2), selon une première relation $A = L^2$, et doté au moins d'une zone vide (B) liée à la dimension du côté (L) et à la dimension au moins d'une zone pleine (D) de l'élément graphique élémentaire (2), égale au moins à la valeur d'épaisseur du côté (L) de la zone totale (A), selon la deuxième relation $B = (L-2D)^2$.

**2.** Procédé, selon la revendication 1, **caractérisé en ce que** la zone vide (B) est apte à favoriser une incidence de la lumière du soleil sur la surface photovoltaïque et que la zone pleine (D) est apte à constituer une zone d'application de la représentation graphique.

**3.** Procédé, selon la revendication 1, **caractérisé en ce que** la représentation graphique perforée est appliquée en recouvrement de la surface photovoltaïque à travers :

- impression directe à travers au moins une insertion de la surface photovoltaïque à l'intérieur au moins d'une imprimante ; et/ou
- réalisation séparée de la représentation graphique avec l'élimination des zones vides (B) à partir des zones pleines (D) selon la grille graphique (1) puis collage sur la surface photovoltaïque ; et/ou
- impression de la représentation graphique perforée sur au moins un support opportunément transparent à coller ou fixer sur la surface photovoltaïque.

4. Procédé, selon la revendication 1, **caractérisé en ce que** la grille graphique (1) est obtenue à travers la répétition de l'élément graphique élémentaire (2) dans trois directions de l'espace, à travers au moins une symétrie rotatoire si l'élément graphique élémentaire (2) est répété autour d'un centre de rotation au moins, ou à travers une symétrie de translation si l'élément graphique élémentaire (2) est répété au moyen d'un déplacement au moins le long d'une ligne ou bien à travers une symétrie miroir si l'élément graphique élémentaire (2) est répété au moyen d'un basculement par rapport à un axe de rotation.

5. Procédé, selon la revendication précédente, **caractérisé en ce que** l'élément graphique élémentaire (2) possède au moins une valeur du rapport en pourcentage (E) égale au moins à un rapport entre la zone vide (B) et la zone totale (A), selon une troisième relation $E = \dfrac{(L-2D)^2}{L^2}$

FIG. 2

FIG.1

FIG. 3

FIG. 4

FIG. 5

EP 3 437 141 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080230118 A
- US 2016072430 A